# EUROPÄISCHE PATENTSCHRIFT

(11) **EP 0 802 012 B1**
(45) Veröffentlichungstag und Bekanntmachung des Hinweises auf die Patenterteilung: **01.12.1999**
(21) Anmeldenummer: 97105755.9
(22) Anmeldetag: 08.04.1997
(51) Int. Cl.: B23K 20/00

(54) **Vorrichtung zum Herstellen von Drahtverbindungen an Halbleiterchips**
Device for making wire connections to semiconductor chips
Dispositif de réalisation de connexions de fils à des puces semi-conductrices

(30) Priorität: 17.04.1996 CH 97396
(43) Veröffentlichungstag der Anmeldung: 22.10.1997
(73) Patentinhaber: ESEC SA, CH-6330 Cham (CH)
(72) Erfinder: Pasquier, Laurent, 8002 Zürich (CH)

(56) Entgegenhaltungen:
- WO-A-84/03823
- WO-A-85/05416
- WO-A-88/04738
- FR-A- 1 334 446
- FR-A- 2 309 009
- US-A- 4 261 211
- US-A- 4 953 834
- US-A- 5 169 050

## Beschreibung

Die Erfindung betrifft eine Vorrichtung zum Herstellen von Drahtverbindungen an Halbleiterchips. Bei der Halbleitermontage werden mittels solcher meist "wire bonder" genannter Vorrichtungen geformte Drahtbrücken zum Anschluss der auf dem Chip befindlichen integrierten Schaltung hergestellt. Dabei befindet sich jeweils der eine Anschlusspunkt der Drahtbrücke auf der Chipoberfläche und der andere Anschlusspunkt auf einem den Chip tragenden Substrat (Systemträger, "lead frame") oder auf einem anderen Chip. Das Kontaktieren, d.h. das Befestigen des Drahtes an den Anschlusspunkten erfolgt z.B. mittels Ultraschallschweissung.

An einer solchen Vorrichtung werden für die Erfindung die nachstehenden Bestandteile und Merkmale vorausgesetzt:
- eine Kontaktierungseinheit, die eine mindestens angenähert senkrecht zur Chipoberfläche auslenkbare, den Verbindungsdraht führende Kapillare trägt,
- einen die Kontaktierungseinheit haltenden, parallel zur Chipoberfläche beweglich geführten Träger,
- und eine die Kontaktierungseinheit mit dem Träger verbindende, federnde Gelenkanordnung, welche wenigstens ein Paar von biegeelastischen Lamellen aufweist, die einander bezüglich einer Symmetrieebene gegenüberstehen und zueinander konvergieren, und die eine zur Chipoberfläche parallele Schwenkachse definieren, welche ausserhalb der Gelenkanordnung liegt.

Eine Vorrichtung dieser Art geht aus der US-Patentschrift Nr. 4,598,853 hervor. Eine weitere, ähnliche Vorrichtung ist in der US-Patentschrift Nr.4,903,883 (oder EP-A 0 340 506) beschrieben; diese unterscheidet sich jedoch vom erstgenannten Stand der Technik in der Ausführung der Gelenkanordnung, welche die Kontaktierungseinheit mit dem Träger verbindet.

Die auf einem Substrat montierten, zu kontaktierenden Chips befinden sich unterhalb der Kontaktierungseinheit und werden in der Vorrichtung taktweise weitertransportiert. Um jeweils eine Drahtbrücke zu formen, führt der Träger zusammen mit der von ihm gehaltenen Kontaktierungseinheit programmierte, koordinierte Bewegungen aus, um die Kapillare auf der erforderlichen Bahn mit Bewegungskomponenten parallel und senkrecht zur Chipoberfläche zu führen (da die Chips normalerweise mit horizontaler Oberfläche verarbeitet werden, kann im folgenden auch einfach von Horizontal- bzw.Vertikalbewegungen gesprochen werden). Die den Träger und die Kontaktierungseinheit verbindende, federnde Gelenkanordnung kommt jeweils beim Kontaktieren des Drahtes, d.h. beim Aufsetzen der Kapillare auf dem Chip oder Substrat "passiv" zur Wirkung: Die Kontaktierungseinheit wird dabei in einer Vertikalebene relativ zum Träger um einen geringen Winkel geschwenkt, wobei die zur Kontaktierung erforderliche Bondkraft erzeugt wird. - Gelenkanordnungen dieser Art mit aussenliegender, "virtueller" Schwenkachse (die also keinen Achsbolzen mit Lager o.dgl. aufweisen), bieten vor allem ausreichend freien Raum unterhalb der Kontaktierungseinheit für einen breiten Werkstückdurchlass. Dies ermöglicht die Bearbeitung von Substraten mit grossflächigen Chips und langen Drahtbrücken, oder von Anordnungen mit mehreren nebeneinander montierten Chips, sogenannten "multi chip devices".

Die erwähnten Bewegungen erfolgen mit hoher Geschwindigkeit, wobei eine sehr hohe Präzision erforderlich ist. Insbesondere darf die Kapillarenspitze beim Aufsetzen keinerlei Horizontalbewegung ausführen. Neben einer hohen Seitenstabilität der erwähnten Gelenkanordnung bedingt dies, dass die Schwenkachse der Gelenkanordnung und die Chipoberfläche bzw. das Substrat praktisch in einer Ebene liegen, so dass die Tangente zur Schwenkbewegung der Kapillare möglichst senkrecht auf der Chipoberfläche steht. Falls der Träger als schwenkbare Wippe ausgebildet ist (wie in der vorgenannten US-Patentschrift Nr. 4,903,883 oder EP-A 0 340 506 dargestellt), muss auch deren Schwenkachse in der gleichen Ebene liegen.

Bei der oben angegebenen, gattungsgemässen Vorrichtung (US-A 4,598,853) werden für die elastische Gelenkanordnung Blattfeder-Abschnitte verwendet, die abgestumpft V-förmig gebogen sind, um jeweils ein Paar biegeelastischer Lamellen zu bilden. Die freien Enden dieser Lamellen sind in Schlitzen am Träger eingeklemmt, während ein dazwischen liegender Abschnitt an einem mit der Kontaktierungseinheit verbundenen Teil festgespannt ist. Beim Herstellen einer solchen Anordnung ist es erfahrungsgemäss schwierig, die Blattfedern mit der erforderlichen Präzision zu biegen, wobei innere Materialspannungen oder Gefügeveränderungen unvermeidlich sind. Ausserdem ist das Einspannen der Blattfeder-Enden in Schlitzen mit Nachteilen verbunden: Die Herstellung von derart schmalen Schlitzen (entsprechend der Blattfederdicke) mit genauer Schlitzbreite und ebenen Flanken ist sehr aufwendig; dabei bewirken aber bereits geringe Abweichungen erhebliche Veränderungen der Einspannung, insbesondere der wirksamen Lamellenlänge. Im Dauerbetrieb können sich ferner die Einspannstellen infolge der wechselnden, elastischen Durchbiegung der Lamellen nach und nach plastisch verformen, was wiederum eine Änderung der Einspannlänge bedeutet. Deshalb sind Gelenkanordnungen dieser Art vor allem bezüglich ihrer Federeigenschaften und der Lage der Schwenkachse schlecht reproduzierbar und wenig stabil.

Mit der vorliegenden Erfindung soll eine Vorrichtung der erwähnten, bekannten Gattung weiterentwickelt werden, um die Nachteile der beschriebenen Gelenkanordnung zu überwinden. Insbesondere soll eine für die Serieherstellung geeignete, federnde Gelenkverbindung mit genau reproduzierbaren und im Dauerbetrieb stabilen Eigenschaften vorgeschlagen werden.

Diese Aufgabe wird erfindungsgemäss dadurch gelöst, dass in der Gelenkanordnung jeweils mindestens zwei konvergierende, elastische Lamellen zusammen mit zwei sie verbindenden, starren Körpern ein einstückiges Gelenkelement in Gestalt eines im wesentlichen trapezförmigen Rahmens bilden, wobei der eine Körper am Träger und der andere Körper an der Kontaktierungseinheit lösbar befestigt ist.

Einstückige Gelenkelemente dieser Art mit zwei oder auch mehreren konvergierenden Lamellen lassen sich relativ einfach, vor allem mit der nötigen Genauigkeit und Konstanz der Federeigenschaften in Serie herstellen. Auch die Montage der Vorrichtung wird mit solchen einheitlichen Bauelementen erheblich vereinfacht, beispielsweise können die starren Körper jedes Gelenkelements an Anschlagflächen des Trägers bzw. der Kontaktierungseinheit ausgerichtet und festgeschraubt werden. Die Gelenkelemente lassen sich als Ganzes leicht auswechseln. Bei Bedarf kann durch Austauschen der Elemente auch z.B. die Lage der Schwenkachse verändert werden.

Ausser für die oben angegebene, erfindungsgemässe Vorrichtung wird auch für das einzelne Gelenkelement (gegebenenfalls für Anwendungen auch in anderem Zusammenhang) Schutz beansprucht.

Die Erfindung wird nachstehend anhand eines Ausführungsbeispiels der Vorrichtung und verschiedener Beispiele von Gelenkelementen im Zusammenhang mit der Zeichnung näher beschrieben.
- Fig. 1: ist eine stark vereinfachte Teildarstellung der Vorrichtung in Seitenansicht,
- Fig. 2: zeigt Teile der Vorrichtung nach Fig. 1 in der Draufsicht,
- Fig. 3: zeigt ein erstes Ausführungsbeispiel eines Gelenkelementes in Stirnansicht,
- Fig. 4: ist die teilweise geschnittene Seitenansicht des Gelenkelementes nach Fig. 3, mit schematischer Darstellung seiner Montage am Träger und an der Kontaktierungseinheit,
- Fig. 5: ist die Stirnansicht einer weiteren Ausführungsform des Gelenkelementes,
- Fig. 6: ist ein zum Ausführungsbeispiel nach Fig. 5 gehörendes Diagramm, welches die Lage der virtuellen Schwenkachse in Abhängigkeit vom Schwenkwinkel zeigt, und
- Fig. 7: zeigt, wiederum in Stirnansicht, eine dritte Ausführungsvariante des Gelenkelementes.

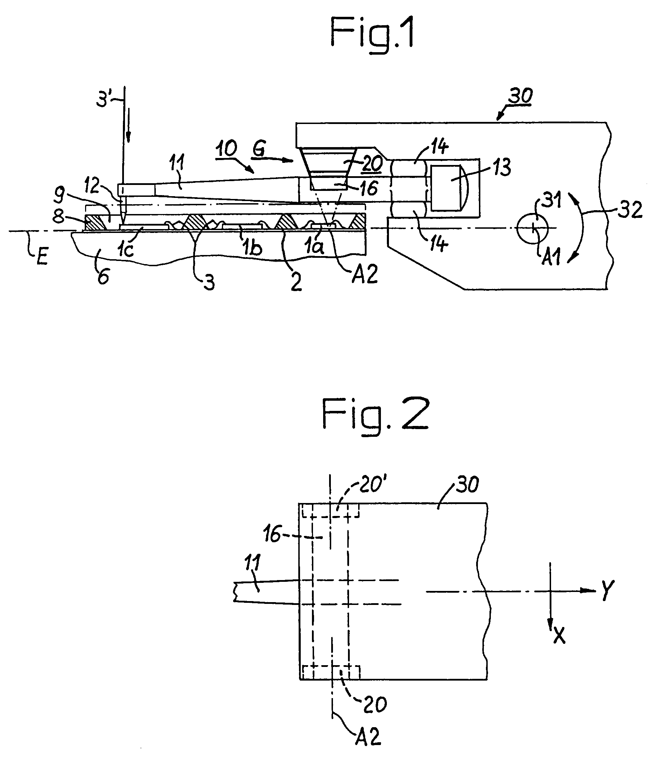

In der stark vereinfachten, schematischen Darstellung der Vorrichtung nach Fig. 1 und 2 sind nur die für die Erfindung wesentlichen Teile wiedergegeben; für weitere, hier nicht dargestellte Einzelheiten, soweit sie den bekannten Stand der Technik betreffen, wird auf die oben erwähnte US-Patentschrift Nr. 4,903,883 oder EP-A 0 340 506 verwiesen. Die Vorrichtung weist eine Kontaktierungseinheit 10 auf, die im vorliegenden Fall zur Herstellung der Drahtverbindungen mittels Ultraschall-Schweissung ausgebildet ist. Die Einheit 10 besteht im wesentlichen aus einem etwa horizontalen "Horn" 11, welches am einen Ende einen Ultraschallgenerator 13 und am anderen Ende eine Kapillare 12 trägt, die den von oben nach unten durch die Kapillare laufenden Verbindungsdraht 3' führt.

Die Kontaktierungseinheit 10 wird von einem Träger gehalten, der im vorliegenden Fall als (nur teilweise dargestellte) Wippe 30 ausgebildet ist. Die Verbindung zwischen Kontaktierungseinheit 10 und Träger (Wippe 30) ist über eine Gelenkanordnung G hergestellt. Diese ist in Fig. 1 und 2 nur schematisch angedeutet und wird weiter unten anhand verschiedener Ausführungsvarianten eingehend beschrieben. Zwischen Wippe 30 und Kontaktierungseinheit 10 sind ferner Dämpfungsorgane 14 angeordnet, die zur Unterdrückung von unerwünschten Prellschwingungen dienen und zu der von der Kapillare 12 beim Kontaktieren ausgeübten Kraft beitragen.

Die Wippe 30, und mit ihr die Einheit 10, wird mit Hilfe von nicht dargestellten, Mikroprozessor-gesteuerten Antriebsmotoren einerseits in der Horizontalebene, d.h. parallel zur Chip-Oberfläche, verschoben (Richtungen X, Y in Fig. 2) und andererseits um eine horizontale Achse A1 geschwenkt (Achsbolzen 31, Pfeil 32 in Fig. 1). Dadurch führt die Spitze der Kapillare 12 die koordinierten Bewegungen aus, die zur Bildung geformter Drahtbrücken 3 erforderlich sind.

Die zu kontaktierenden Werkstücke befinden sich unterhalb der Kontaktierungseinheit 10 und werden auf einem horizontalen Tisch 6 der Vorrichtung jeweils quer zur Längserstreckung des Horns 11 (X-Richtung) vorgeschoben. Als Beispiel ist ein Substrat 2, z.B. ein metallischer "lead frame", mit darauf montierten Chips 1a, 1b, 1c dargestellt. Drahtverbindungen 3 werden mittels der Kapillare 12 jeweils zwischen der Oberfläche eines Chips 1 und dem Substrat 2, gegebenenfalls auch von Chip zu Chip, hergestellt. Beim vorliegenden Beispiel befinden sich auf dem Substrat 2 jeweils drei (gleiche oder verschiedene) Chips 1a, 1b, 1c in einer Reihe und können somit bei gleichbleibender Vorschubstellung des Werkstücks bzw. Substrats kontaktiert werden. Eine solche vorteilhafte Arbeitsweise - allenfalls auch die Verarbeitung grosser Einzelchips - setzt allerdings eine entsprechende freie Durchlassbreite unter der Einheit 10 in Y-Richtung voraus. Während der Bearbeitung wird das Werkstück (Substrat 2 mit Chips 1) mittels einer mit "Fenstern" 9 versehenen Niederhalterplatte 8 flach auf dem Tisch 6 gehalten. Um den Vorschub des Werkstücks zu ermöglichen, muss diese Platte 8 jeweils angehoben werden, wie in Fig. 1 strichpunktiert angedeutet ist.

Jedesmal, wenn die Spitze der Kapillare 12 beim Kontaktieren die Oberfläche eines Chips 1 oder des Substrats 2 berührt, wird die Kontaktierungseinheit 10 an der Gelenkanordnung G um einen kleinen Winkel relativ zur Wippe 30 vertikal ausgelenkt, und zwar um eine zweite Schwenkachse A2, die zur ersten Schwenkachse A1 der Wippe 30 parallel verläuft und zwischen dieser und der Kapillare 12 liegt. Wie weiter oben bereits ausgeführt, darf die Kapillare sich dabei nicht seitlich (horizontal) bewegen, d.h. die Tangente der Schwenkbewegung um die Achse A2 soll möglichst senkrecht zum Werkstück stehen. Dies bedingt wiederum, dass die erste Achse A1, die zweite Achse A2 und das Werkstück in einer gemeinsamen Ebene E (Fig. 1) liegen (der geringe Höhenunterschied zwischen den Oberflächen des Chips 1 und des Substrats 2 kann dabei vernachlässigt werden).

Die Gelenkanordnung G, welche die Kontaktierungseinheit 10 mit der Wippe 30 verbindet, ist so gestaltet, dass die von ihr definierte Schwenkachse A2 ausserhalb der Gelenkanordnung selbst und auch jenseits (unterhalb) der Kontaktierungseinheit 10 verläuft. Es handelt sich um eine "virtuelle" Achse, also nicht um ein materielles Lager mit Achsbolzen o.dgl. an der Stelle von A2. Somit ist der Arbeits- oder Durchlassbereich der Vorrichtung nicht durch ein solches materielles Lager begrenzt, sondern kann auch den Bereich der "virtuellen" Achse A2 umfassen.

Die Gelenkanordnung G weist vorzugsweise zwei Gelenkelemente 20 auf, deren Aufbau und Wirkungsweise weiter unten anhand verschiedener Varianten beschrieben wird. Wie aus der Fig. 2 hervorgeht, sind aus Gründen der Seitenstabilität zwei solche Gelenkelemente 20, 20' vorgesehen, die zu beiden Seiten der Kontaktierungseinheit 10 angeordnet und mit ihrer jeweiligen Schwenkachse aufeinander ausgerichtet sind; die Verbindung jedes Gelenkelementes 20, 20' mit der Einheit 10 erfolgt z.B. über eine Traverse 16. Grundsätzlich könnte aber ein einziges, mittig angeordnetes Gelenkelement 20 ausreichen, das die Wippe 30 mit der Einheit 10 direkt, d.h. ohne Traverse 16 verbindet.

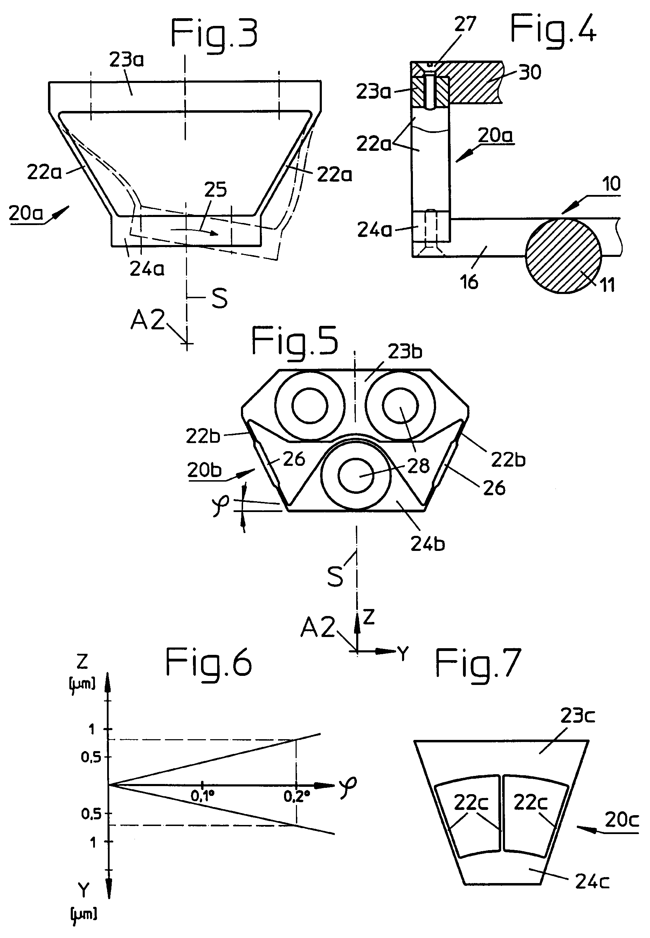

Ein erstes Ausführungsbeispiel eines Gelenkelementes 20a ist in den Fig. 3 und 4 dargestellt. Ein solches Element besteht grundsätzlich aus zwei (oder auch mehreren) biegeelastischen Lamellen 22a, die einander bezüglich einer Symmetrieebene S gegenüberstehen und zueinander konvergieren. Die Lamellen 22a sind an ihrem einen Ende mit einem ersten starren Körper 23a und an ihrem anderen Ende mit einem zweiten starren Körper 24a einstückig verbunden. Das Gelenkelement 20a ist also als einstückges Teil aus dem Vollen hergestellt und hat die Gestalt eines geschlossenen, im wesentlichen trapezförmigen Rahmens. Wie aus Fig. 4 ersichtlich, ist der eine Körper 23a am Träger 30 und der andere Körper 24a an der Traverse 16 der Kontaktierungseinheit 10 lösbar befestigt, z.B. mittels Schrauben 27.

Es wurde festgestellt, dass beim Verbiegen der Lamellen, wie in Fig. 3 strichpunktiert angedeutet, diese als eine Art "elastische Lenker" wirken, die den einen Körper 24a auf einer Rotationsbewegung gemäss Pfeil 25 in Fig. 3 relativ zum andern Körper 23a führen. Es wird dadurch eine virtuelle Achse A2 definiert, die ausserhalb des Gelenkelementes auf der Seite des kleineren Lamellenabstandes in der Symmetrieebene S liegt, und zwar im Abstand, wo sich die (gedachten, geraden) Verlängerungen der Lamellen schneiden. Vorausgesetzt wird selbstverständlich, dass mit der Verbiegung der Lamellen der elastische Bereich bzw. die zulässige Biegebeanspruchung des Lamellenmaterials nicht überschritten werden. Mit dem Gelenkelement wird somit eine Gelenkanordnung realisiert, die sich durch gute Lagekonstanz der Schwenkachse (sehr geringe, der Rotation überlagerte Translationsbewegung), gute mechanische Stabilität und überdies durch völlige Reibungs- und Spielfreiheit auszeichnet.

Die Fig. 5 zeigt ein weiteres, konkretes Ausführungsbeispiel eines Gelenkelementes 20b, welches speziell zur Anwendung bei einer Vorrichtung nach Fig. 1 und 2 gestaltet wurde. Das Federelement 20b ist einstückig aus Flachmaterial von 2mm Dicke gefertigt. Die beiden konvergierenden Lamellen 22b schliessen einen Winkel von 50° ein und sind in ihren Endabschnitten o,15mm dick. Der grössere Lamellenabstand (am Übergang zum Körper 23b) beträgt ca. 14,4mm und der kleinere Lamellenabstand (am Übergang zum Körper 24b) ca. 9,2mm. Die Distanz der Schwenkachse A2 vom unteren Rand des Körpers 24b beträgt ca. 9,5mm. Die Körper 23b und 24b sind mit Durchgangsbohrungen 28 zur lösbaren Befestigung des Federelementes am Träger (Wippe 30) bzw. an der Kontaktierungseinheit 10 versehen.

Die beiden Lamellen 22b weisen in einem mittleren Abschnitt eine Verdickung 26 auf und sind dadurch versteift, so dass die elastische Biegung hauptsächlich in den Endbereichen der Lamellen stattfindet. Eine entsprechende Versteifung könnte auch auf andere Weise erreicht werden, z.B. durch in Längsrichtung der Lamellen verlaufende Sicken. Die Versteifung der Lamellen dient hauptsächlich dazu, deren Knickfestigkeit zu erhöhen. Aus der Fig. 1 geht hervor, dass die erforderliche, von der Kapillare 12 auszuübende Kontaktierungskraft bei Auslenkung der Einheit 10 teilweise durch die Federwirkung der Gelenkelemente 20 und zum (grösseren) Teil infolge Verformung der Dämpfungselemente 14 erzeugt wird. Wie leicht zu erkennen ist, erfahren die Lamellen dabei eine Knickbeanspruchung, die mit der erwähnten Versteifung aufgenommen werden soll.

Die massgebenden mechanischen Eigenschaften des Gelenkelementes 20b nach Fig. 5 wurden mittels Modellrechnungen nach der Methode der Finiten Elemente ermittelt. In einem konkreten Fall wird die erforderliche Kontaktierungskraft der Kapillare 12 bei einer Schwenkung (Auslenkung) der Kontaktierungseinheit 10 und mit ihr des Körpers 24b des Gelenkelementes von 0,2° relativ zum Körper 23b bzw. zur Wippe 30 erreicht (Winkel ϕ, in Fig. 4 übertrieben dargestellt). Im Diagramm nach Fig. 6 sind in Funktion des Winkels ϕ die ermittelten vertikalen und horizontalen Verschiebungen der Achse A2 (Richtungen Z und Y in Fig. 5) dargestellt. Es zeigt sich, dass die Verschiebungen in beiden Richtungen äusserst gering sind und praktisch linear zum Schwenkwinkel verlaufen; bei ϕ = 0,2° betragen sie weniger als 1µm. Die dabei auftretende Verformung der Lamellen ist vollkommen elastisch, d.h. reversibel.

Die Fig. 7 zeigt schliesslich noch eine weitere Variante eines Gelenkelementes 20c, bei welchem die Körper 23c, 24c durch drei elastische, konvergierende Lamellen 22c verbunden sind. Die Wirkungsweise dieses Elementes, mit den Lamellen als "elastische Lenker", ist grundsätzlich dieselbe wie diejenige der Beispiele nach Fig. 3, 4 und 5. Es soll lediglich gezeigt werden, dass auch mehr als zwei Lamellen möglich sind und damit die mechanischen Eigenschaften, wie Federkonstante, Knicksteifigkeit usw., nach den jeweiligen Erfordernissen dimensioniert werden können.

Einstückige Gelenkelemente der vorstehend beschiebenen Art (20a, 20b, 20c) lassen sich mit der erforderlichen Genauigkeit ohne besondere Schwierigkeiten serienweise herstellen. Eine geeignete Fertigungsmethode ist beispielsweise die Herstellung aus Flachmaterial, wobei das innerhalb des geschlossenen Rahmens liegende Material mittels elektroerosiver Bearbeitung (sogenannte Funkenerosion) ausgeschnitten wird, und zwar nach dem bekannten, als "Drahterosion" bezeichneten Verfahren. Dabei befindet sich das Werkstück in einem Bad mit dielektrischer Flüssigkeit, während ein als Erosions-Elektrode dienender Draht in vertikaler Richtung geführt und eine Vorschubbewegung entsprechend der gewünschten Schnittlinie quer zur Drahtrichung erzeugt wird. Die Aussenkontur der Werkstücke kann nach der gleichen Methode oder auch durch spanabhebende Bearbeitung erzeugt werden.

Wie aus der vorstehenden Beschreibung von Ausführungsbeispielen hervorgeht, lässt sich die Gelenkanordnung G, bestehend aus einstückigen Gelenkelementen 20, sehr einfach montieren, und es entstehen dabei eindeutig reproduzierbare und stabile Verhältnisse bezüglich der Lage der Schwenkachse A2, der Federeigenschaften usw. Die Gelenkelemente können bei Bedarf auch rasch und leicht ausgewechselt werden. Durch Verwendung verschiedener Typen solcher Elemente mit verschiedenem Konvergenzwinkel zwischen den Lamellen 22 kann auch die Lage der Schwenkachse A2 geändert werden, ohne dass an den Montagestellen bzw. Anschlagflächen des Trägers 30 und der Kontaktierungseinheit 10 Änderungen erforderlich sind.

## Patentansprüche

1. Vorrichtung zum Herstellen von Drahtverbindungen (3) an Halbleiterchips (1),
mit einer Kontaktierungseinheit (10), die eine mindestens angenähert senkrecht zur Chipoberfläche auslenkbare, einen Verbindungsdraht (3') führende Kapillare (12) trägt,
einem die Kontaktierungseinheit (10) haltenden, parallel zur Chipoberfläche beweglich geführten Träger (30),
und einer die Kontaktierungseinheit (10) mit dem Träger (30) verbindenden, federnden Gelenkanordnung (G), welche wenigstens ein Paar von biegeelastischen Lamellen (22) aufweist, die einander bezüglich einer Symmetrieebene (S) gegenüberstehen und zueinander konvergieren, und die eine zur Chipoberfläche parallele Schwenkachse (A2) definieren, welche ausserhalb der Gelenkanordnung (G) liegt, dadurch **gekennzeichnet,**
dass jeweils mindestens zwei konvergierende Lamellen (22) zusammen mit zwei sie verbindenden, starren Körpern (23, 24) ein einstückiges Gelenkelement (20) in Gestalt eines im wesentlichen trapezförmigen Rahmens bilden, wobei der eine Körper (23) am Träger (30) und der andere Körper (24) an der Kontaktierungseinheit (10) lösbar befestigt ist.

2. Vorrichtung nach Anspruch 1, dadurch gekennzeichnet, dass die Lamellen (22b) je in einem mittleren Bereich ihrer Länge versteift, vorzugsweise verdickt (26) sind.

3. Vorrichtung nach Anspruch 1, dadurch gekennzeichnet, dass die Gelenkanordnung (G) zwei Gelenkelemente (20, 20') aufweist, die zu beiden Seiten der Kontaktierungseinheit (10) angeordnet und mit ihrer jeweiligen Schwenkachse (A2) aufeinander ausgerichtet sind.

4. Vorrichtung nach einem der vorangehenden Ansprüche, dadurch gekennzeichnet, dass der Träger (30) durch eine Wippe gebildet ist, die um eine zur Schwenkachse (A2) der Gelenkanordnung (G) parallele Achse (A1) schwenkbar gelagert ist.

5. Federndes Gelenkelement (20) mit mindestens zwei biegeelastischen Lamellen (22), die einander bezüglich einer Symmetrieachse (S) gegenüberstehen und zueinander konvergieren, und die eine Schwenkachse (A2) definieren, welche in der Symmetrieebene und ausserhalb des Gelenkelementes liegt, dadurch **gekennzeichnet,** dass die Lamellen (22) zusammen mit zwei sie verbindenden, starren Körpern (23, 24) einen einstückigen, im wesentlichen trapezförmigen Rahmen bilden.

6. Gelenkelement nach Anspruch 5, dadurch gekennzeichnet, dass die Lamellen (22b) in einem mittleren Bereich ihrer Länge versteift, vorzugsweise verdickt sind (26).

## Claims

1. Apparatus for making wire connections (3) on semiconductor chips (1), with a bonding unit (10) carrying a capillary (12) which is movable in a direction at least approximately perpendicular to the chip's surface and guides a bonding wire, with a support unit (30) movably guided parallel to the chip's surface and carrying the bonding unit (10); and with resilient articulating means (G) linking the bonding unit (10) to the support unit (30) and comprising at least one pair of flexible blades (22) which are arranged opposite each other relative to a symmetry plane (S) and which converge to each other and which define a pivot axis (A2) which extends parallel to the chip's surface and lies outside the resilient articulating means (G), characterized in that at least two converging, flexible blades (22) form together with two rigid bodies (23, 24) which connect them a one-piece joint element (20) having the shape of an essentially trapezoid frame, wherein the one rigid body (23) is removably attached to the support unit (30) and the other rigid body (24) is removably attached to the bonding unit (10).

2. Apparatus according to claim 1, characterized in that the blades (22b) are each stiffened in a longitudinal mid-section, preferrably thickened (26).

3. Apparatus according to claim 1, characterized in that the resilient articulating means (G) comprises two joint elements (20, 20') placed on each side of the bonding unit (10) with their respektive pivot axes (A2) aligned with each other.

4. Apparatus according to one of the preceding claims, characterized in that the support unit (30) is formed by a rocker which is pivotally mounted with a pivot axis (A1) extending parallel to the pivot axis (A2) of the resilient articulating means (G).

5. Resilient joint element (20) with at least two flexible blades (22) arranged opposite each other relative to a symmetry axis (S) and converging to each other and defining a pivot axis (A2) extending in the symmetry plane and outside the joint element, characterized in that the converging blades (22) and two rigid bodies (23, 24) connecting them form a one-piece and essentially trapezoid frame.

6. Joint element according to claim 5, characterized in that the blades (22b) are each stiffened in a longitudinal mid-section, preferrably thickened (26).

## Revendications

1. Dispositif pour établir des liaisons filaires (3) à des puces de semi-conducteur (1), avec
une unité de mise en contact (10), qui porte un capillaire (12) amenant le fil de liaison (3') pour l'approcher au moins selon une excursion au moins approximativement perpendiculaire à la surface de la puce,
un support (30) maintenant l'unité de mise en contact (10), piloté pour être mobile de manière parallèle à la surface de la puce,
et un agencement articulé élastique (G), reliant l'unité de mise en contact (10) au support (30), lequel présente au moins une paire de lamelles cintrées de manière élastique (22), qui se font face l'une à l'autre par rapport à un plan de symétrie (S) et convergent l'une vers l'autre, et qui définissent un axe de pivotement (A2) parallèle à la surface de la puce, lequel se trouve en dehors de l'agencement articulé,
caractérisé en ce que, au besoin,
au moins deux lamelles (22) convergentes, élastiques forment respectivement, avec deux corps rigides (23, 24) qui les relient, un élément articulé d'une seule pièce (20) ayant la forme d'un cadre sensiblement trapézoïdal, les corps étant reliés, de manière amovible, l'un (23) au support (30) d'une part et l'autre (24) à l'unité de mise en contact (10) d'autre part.

2. Dispositif conforme à la revendication 1, caractérisé en ce que, les lamelles (22b) sont chacune renforcées dans une région médiane de leur longueur, de préférence par une surépaisseur (26).

3. Dispositif conforme à la revendication 1, caractérisé en ce que, l'agencement articulé (G) comporte deux éléments articulés (20, 20'), qui sont arrangés sur les deux côtés de l'unité de mise en contact (10) et dont les axes de pivotement (A2) respectifs sont alignés l'un avec l'autre.

4. Dispositif conforme à l'une quelconque des revendications précédentes, caractérisé en ce que, le support (30) est formé d'une bascule, qui est positionnée de manière à pouvoir pivoter autour d'un axe (A1) parallèle à l'axe de pivotement (A2) de l'agencement articulé (G).

5. Elément articulé formant ressort (20) avec au moins une paire de lamelles cintrées de manière élastique (22), qui se font face l'une à l'autre par rapport à un axe de symétrie (S) et convergent l'une vers l'autre, et qui définissent un axe de pivotement (A2), lequel se trouve en dehors dans le plan de symétrie et au dehors de l'agencement articulé, caractérisé en ce que,
les lamelles (22) forment, avec deux corps rigides (23, 24) qui les relient, un cadre d'une seule pièce de forme sensiblement trapézoïdale.

6. Elément articulé conforme à la revendication 5, caractérisé en ce que, les lamelles (22b) sont renforcées dans la région médiane de leur longueur, de préférence par une surépaisseur(26).
